# FASCICULE DE BREVET EUROPEEN

(11) **EP 0 638 929 B1**
(45) Date de publication et mention de la délivrance du brevet: **10.03.1999**
(21) Numéro de dépôt: 94410064.3
(22) Date de dépôt: 05.08.1994
(51) Int. Cl.: H01L 23/495

(54) **Dissipateur thermique pour boîtier plastique**
Wärmesenke für Plastikpackung
Heat sink for plastic package

(30) Priorité: 09.08.1993 FR 9309931
(43) Date de publication de la demande: 15.02.1995
(73) Titulaire: STMicroelectronics S.A., 94250 Gentilly (FR)
(72) Inventeur: Moscicki, Jean-Pierre, F-38120 Saint Egreve (FR)
(74) Mandataire: de Beaumont, Michel

(56) Documents cités:
- PATENT ABSTRACTS OF JAPAN vol. 008, no. 074 (E-236) 6 Avril 1984 & JP-A-58 223 353 (TOKYO SHIBAURA DENKI KK) 24 Décembre 1983
- PATENT ABSTRACTS OF JAPAN vol. 013, no. 235 (E-766) 30 Mai 1989 & JP-A-01 041 253 (MITSUBISHI ELECTRIC CORP.) 13 Février 1989
- PATENT ABSTRACTS OF JAPAN vol. 013, no. 544 (E-855) 6 Décembre 1989 & JP-A-01 225 190 (CANON INC) 8 Septembre 1989

## Description

La présente invention concerne les boîtiers de composants semiconducteurs, et plus particulièrement les boîtiers de circuits intégrés à grand nombre de broches obtenus par moulage dans une matière plastique thermo-durcissable.

Avec l'augmentation des capacités d'intégration des circuits sur des puces de silicium, la puissance susceptible d'être dissipée par ces circuits augmente et, alors que la dissipation de puissance d'un circuit intégré était souvent considérée comme négligeable, on arrive maintenant à des circuits intégrés ayant des dissipations du même ordre de grandeur que des composants discrets, par exemple de l'ordre d'une dizaine de watts. Dans ce cas, l'enrobage de toutes les faces d'une puce de silicium par une matière plastique thermo-durcissable thermiquement conductrice, telle qu'une résine époxy chargée de silice, ne permet pas d'assurer la dissipation thermique nécessaire.

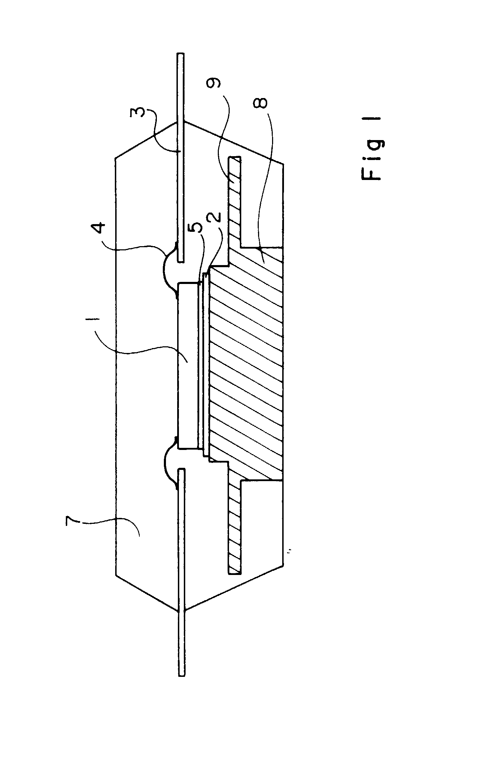

Pour résoudre ce problème, on a proposé des boîtiers du type de celui représenté schématiquement en coupe en figure 1. Ce boîtier, destiné à assurer la protection et la connexion d'une puce de circuit intégré, contient cette puce 1 posée sur une partie support 2 d'une grille de connexion comprenant par ailleurs des éléments 3 formant des broches de connexion dont chacune est reliée à un plot de la puce par un fil conducteur 4. Classiquement, l'assemblage entre la puce 1 et le support 2 est assuré par une couche de colle thermiquement conductrice 5. L'ensemble est moulé dans une résine thermodurcissable 7 de sorte que les broches 3 sortent vers l'extérieur. Ce boîtier a souvent une forme carrée ou rectangulaire et comprend des broches sur ses quatre côtés. Il a typiquement une dimension de quelques centimètres de côté et une hauteur normalisée de par exemple 3,6 mm. Il est souvent désigné dans la technique par l'appellation PQFP, d'après les termes anglo-saxon Plastic Quad Flat Pack (boîtier plat à quatre côtés en matière plastique). En outre, quand on veut que la puce puisse dissiper une quantité de chaleur relativement importante, on rajoute une embase dissipatrice 8 sur laquelle repose le support 2 et qui s'étend jusqu'à la face apparente inférieure du boîtier. Cette embase est par exemple, comme le représente la figure 1, munie d'ailettes 9. Cette embase est généralement métallique, couramment en cuivre ou en aluminium.

Classiquement, les embases 8, qui ont une épaisseur de 1 à 2 mm, sont fabriquées à la presse, ce qui, en particulier quand elles sont en aluminium, implique un procédé de fabrication complexe nécessitant des investissements lourds. Un autre problème avec de tels boîtiers est que, après injection de la résine dans un moule, tandis que celle-ci durcit, elle présente pendant sa polymérisation un taux de contraction bien supérieur à la contraction thermique du silicium et des divers métaux, en particulier de celui constituant l'embase. Il peut en résulter une torsion du boîtier qui se voile pour devenir concave du côté de la face supérieure où le volume de résine est plus grand. Cette déformation entraîne divers défauts de qualité, et notamment d'ancrage entre la résine et les éléments qu'elle contient, et peut aller jusqu'à provoquer le bris de la puce de silicium.

La demande de brevet japonais JP-A-1041253 propose de former une embase par repliement en deux d'une feuille.

Un objet de la présente invention est de prévoir une structure particulière d'embase dissipatrioe qui résolve à la fois les problèmes de difficulté de fabrication et de déformation.

Pour atteindre ces objets, la présente invention prévoit une embase telle que définie en revendication 1.

Selon un mode de réalisation de la présente invention, la plate-forme à partir de laquelle sont repliées des languettes se prolonge par des ailettes qui lui sont liées par des bras de liaison.

Selon un mode de réalisation de la présente invention, chacun des bras de liaison est courbé pour que, après pliage, la face inférieure des ailettes se trouve dans le même plan que la face inférieure des languettes.

Selon un mode de réalisation de la présente invention, les bras de liaison des ailettes partent sensiblement des milieux des côtés de la plate-forme avant pliage des languettes.

Selon un mode de réalisation de la présente invention, les repliements de languettes sont non-jointifs.

Selon un mode de réalisation de la présente invention, les repliements sont non-jointifs au moins au niveau des coins de la plate-forme après pliage de sorte que la plate-forme est au moins partiellement en surplomb par rapport à la face inférieure.

Selon un mode de réalisation de la présente invention, ladite feuille, avant repliement, est munie d'ouvertures au niveau des lignes de pliage, au moins à l'extérieur des lignes de pliage.

Selon un mode de réalisation de la présente invention, l'embase est constituée à partir d'une feuille d'aluminium.

Ces objets, caractéristiques et avantages ainsi que d'autres de la présente invention seront exposés en détail dans la description suivante de modes de réalisation particuliers faite à titre non-limitatif en relation avec les figures jointes parmi lesquelles :
la figure 1, décrite précédemment, est une vue en coupe schématique d'un boîtier plastique à embase dissipatric;
la figure 2A est une vue de dessous d'une embase selon un mode de réalisation de la présente invention;
la figure 2B est une vue en coupe selon la ligne B-B de la figure 2A ;
la figure 2C est une vue en coupe selon la ligne C-C de la figure 2A ;
les figures 3A, 3B et 3C illustrent une variante de réalisation de l'embase selon la présente invention ; et
les figures 4A, 4B et 4C illustrent une autre variante de réalisation de l'embase selon la présente invention.

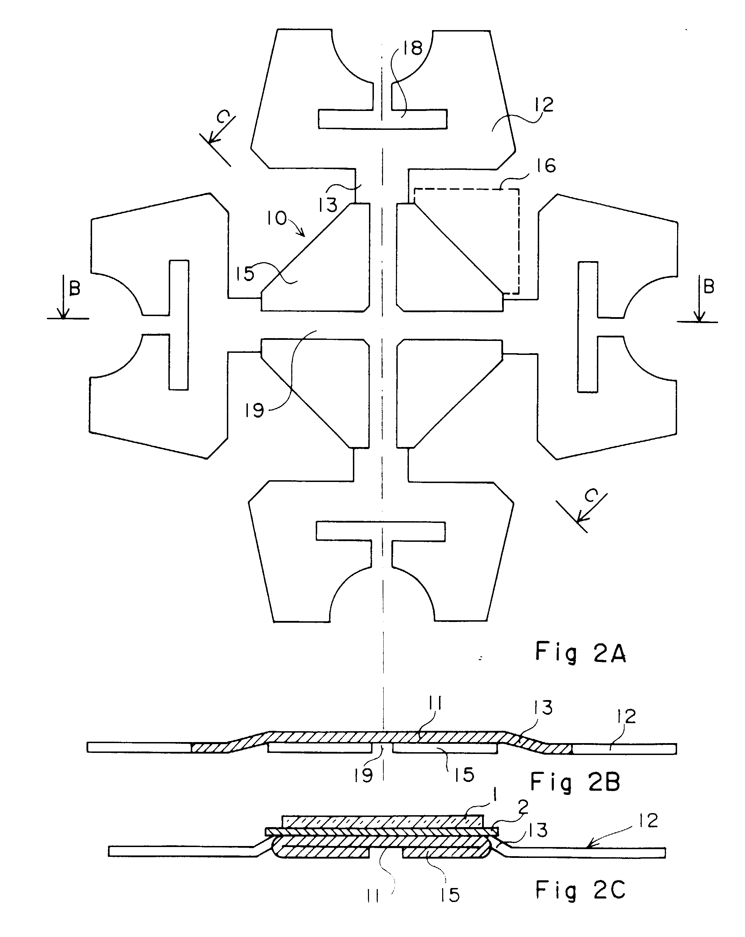

Comme le représentent la vue de dessous de la figure 2A et les vues en coupe des figures 2B et 2C, l'embase selon la présente invention comprend une partie de plate-forme 10 de forme générale carrée destinée à recevoir le support de puce 2 de la figure 1 sur sa face 11 opposée à celle apparente sur la figure 2A, c'est-à-dire sur la face supérieure des vues en coupe des figures 2B et 2C. Cette plate-forme, le support de puce 2 et la puce 1 sont d'ailleurs illustrés en figure 2C. La puce peut éventuellement être directement posée sur la plate-forme. La plate-forme 10 est reliée à des ailettes 12 par des bras de liaison 13.

L'ensemble de la structure est fabriqué à partir d'une feuille métallique convenablement découpée ayant par exemple une épaisseur de 0,8 mm. La partie centrale de l'embase est initialement découpée sous forme d'un carré et chacun des coins de ce carré constituant une languette 15 est rabattu sur la face inférieure de la feuille, visible dans la figure 2A. On a représenté en pointillés et désigné par la référence 16 la forme d'une ébauche de languette avant repliement. Comme le montrent les figures 2B et 2C, les bras de liaison 13 entre la plate-forme 10 et les ailettes 12 sont de préférence incurvés pour que la face inférieure de chacune des ailettes soit dans le même plan que la face inférieure, après repliement, des languettes 15. Ainsi, après moulage dans la résine, les faces inférieures des ailettes 12 affleureront à la surface inférieure du boîtier comme les faces inférieures des languettes 15.

Les ailettes 12 pourront prendre toute forme choisie par l'homme de métier mais comprendront de préférence des échancrures, telles que l'échancrure 18 illustrée en figure 2A et destinée à assurer un meilleur ancrage de la résine de moulage dans l'ailette. L'obtention d'un bon ancrage de l'embase selon la présente invention dans la résine est d'ailleurs l'un des problèmes que vise à résoudre la présente invention. Dans le mode de réalisation de la figure 2A, un ancrage particulièrement satisfaisant est assuré du fait que les languettes 15 après repliement ne sont pas jointives et laissent subsister entre elles deux canaux orthogonaux 19. Lors du moulage, de la résine pénètrera dans ces canaux et sous les bras de liaison 13 et assurera ainsi un excellent ancrage de l'embase et une répartition plus égale de la résine entre le volume existant du côté supérieur et le volume existant du coté inférieur du boîtier.

Selon un aspect de la présente invention illustré en figure 2C, la portion 2 de la grille de connexion servant de support à la puce 1 déborde par rapport à la surface ou au moins par rapport à une partie de la surface de la plate-forme 10 de façon également à améliorer l'ancrage de la résine. Par contre, la dimension de la plate-forme 10 est choisie supérieure à celle de la puce 1 pour assurer une bonne dissipation thermique de la puce vers la face inférieure des languettes repliées contre la plate-forme.

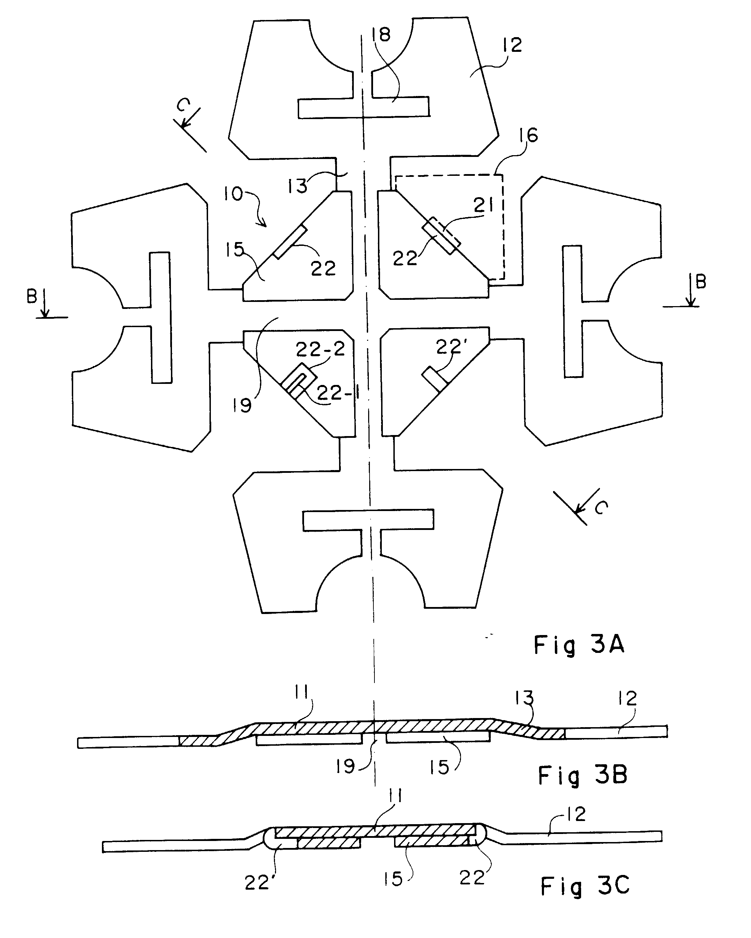

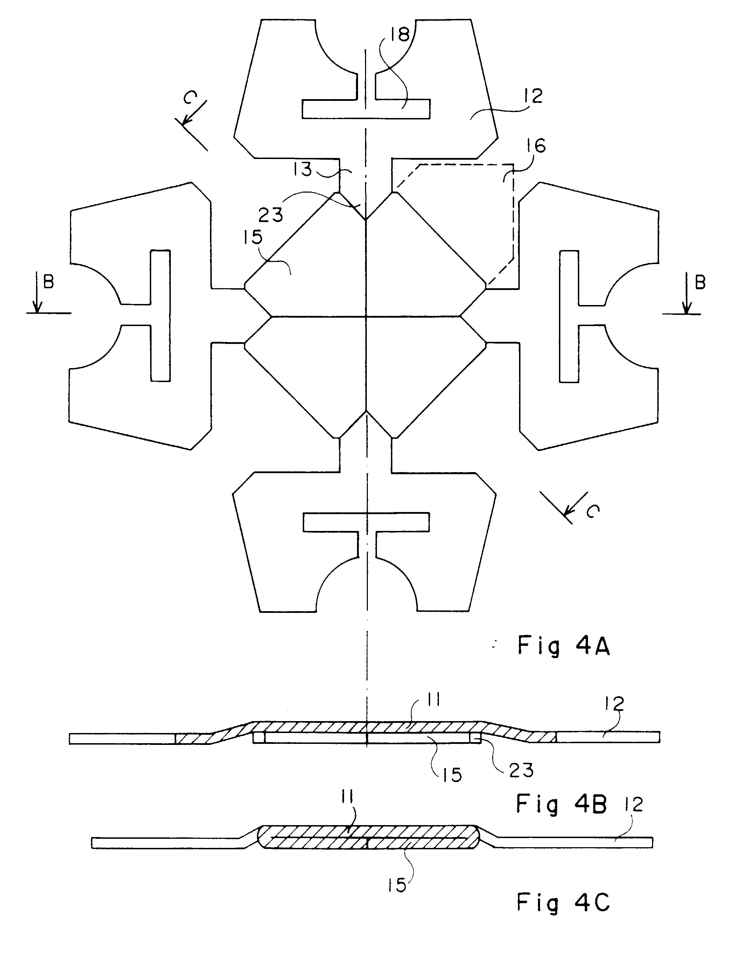

Les figures 3A, 3B et 3C et 4A, 4B et 4C qui correspondent respectivement aux figures 2A, 2B et 2C, c'est-à-dire qu'elles représentent une vue de dessous et des vues en coupe selon les lignes B-B et C-C d'une embase, illustrent des variantes de la présente invention.

Dans toutes ces figures, de mêmes références désignent des éléments similaires.

Dans la variante de la figure 3, avant de replier l'ébauche de languette 16, on a formé dans la feuille métallique une fenêtre 21 à la limite de la zone de pliage. Ainsi, on retrouve après pliage une ouverture 22 dans chacune des languettes 15. Cette ouverture apparaît nettement en figures 3A et 3C alors que la figure 3B est identique à la figure 2B. Les emplacements des ouvertures 22 correspondent à une pénétration de la résine sous la plate-forme et les ouvertures participent ainsi à l'amélioration de l'ancrage. Dans une variante illustrée dans le quadrant inférieur droit de la figure 3A, il est prévu une ouverture radiale 22'. Dans une variante illustrée dans le quadrant inférieur gauche de la figure, il est prévu une ouverture radiale 22-1 dans la plate-forme 11 et une ouverture plus étendue 22-2 dans la languette correspondante. L'ouverture pourrait aussi avoir une forme en croix, ou autre.

On notera d'ailleurs que lors du repliement des ébauches 16 pour former les languettes 15, il n'est pas nécessaire de prendre des précautions particulières pour assurer un bon état de surface du bourrelet apparent de la zone de repliement. En effet, si ce bourrelet est fissuré, cela ne nuit pas au fonctionnement du dispositif et au contraire assure un meilleur accrochage de la résine.

Dans le mode de réalisation de la figure 4, la pré-découpe des ébauches 16 est assurée pour que les languettes 15 soient jointives après repliement. Ceci augmente la surface de dissipation thermique. Toutefois, on préférera dans ce cas une découpe des ébauches 16 telle qu'après repliement les languettes 15 laissent en place des évidements 23 sous la plate-forme 10 dans le prolongement des bras de liaison 13, à nouveau pour assurer un bon ancrage de la résine. On combinera avantageusement la variante de la figure 3 à celle de la figure 4.

Un avantage de la structure selon la présente invention est que la partie centrale a une épaisseur double et définit une plate-forme rigide pratiquement indéformable sur laquelle la résine, par la qualité des structures d'ancrage, assure la mise en pression de la face inférieure du support 2 et garantit ainsi la planéité du support 2 et un bon contact thermique.

En revanche, les ailettes, éventuellement évidées, ont une épaisseur simple et forment donc des structures souples qui suivent le retrait de la résine en générant un minimum de contraintes.

Comme on l'a indiqué précédemment, l'embase selon la présente invention se prête à une fabrication simple puisqu'elle peut être réalisée par découpe et pliage ce qui nécessite seulement un outillage à faible coût. De préférence, et comme cela est classique dans le domaine des fabrications industrielles, un grand nombre d'embases sera formé séquentiellement à partir d'un ruban ou d'une plaque allongée, ces embases restant solidaires de ce ruban ou de cette plaque jusqu'aux étapes finales de fabrication. On peut alors procéder à des traitements chimiques, physiques, thermiques, électrothermiques ou physico-chimiques des embases tandis qu'elles sont encore regroupées. Si les embases sont en aluminium, on pourra par exemple procéder à une anodisation ou autre traitement destiné à améliorer la rugosité de ces embases de façon à améliorer leur ancrage dans la résine, à améliorer leur aspect, à les débarrasser de tout produit polluant...

Les repliements pourront simplement être assurés par des poinçons et l'on obtient, comme cela est souhaité, une embase dont les faces supérieure et inférieure sont planes et parallèles entre elles.

Bien entendu, la présente invention est susceptible de nombreuses variantes et modifications qui apparaîtront à l'homme de l'art, notamment en ce qui concerne les formes choisies, à savoir la forme des plate-formes, la forme des languettes repliées et la forme et le nombre des ailettes. De même, bien que la mise en oeuvre de la présente invention soit particulièrement avantageuse dans le cas d'une structure en aluminium, elle pourrait également s'appliquer à des embases en d'autres matériaux, par exemple en cuivre.

## Revendications

1. Embase servant de dissipateur thermique dans un boîtier en matière plastique, la face supérieure (11) de l'embase étant en contact thermique avec une puce semiconductrice (1), la face inférieure (15) affleurant au niveau d'une face principale du boîtier, caractérisée en ce qu'elle est constituée à partir d'une feuille métallique sensiblement carrée dont chacun des coins est replié en languette (15) pour obtenir une plate-forme (11) sensiblement carrée, la face comprenant des repliements correspondant à la face inférieure de la plate-forme, et en ce que des ailettes (12) sont liées à la plate-forme (11) par des bras de liaison (13).

2. Embase selon la revendication 1, caractérisée en ce que chacun des bras de liaison (13) est courbé pour que, après pliage, la face inférieure des ailettes se trouve dans le même plan que la face inférieure des languettes.

3. Embase selon la revendication 1, caractérisée en ce que les bras de liaison des ailettes partent sensiblement des milieux des côtés de la plate-forme avant pliage des languettes.

4. Embase selon la revendication 1, caractérisée en ce que les repliements de languettes sont non-jointifs.

5. Embase selon la revendication 1, caractérisée en ce que les repliements sont non-jointifs au moins au niveau des coins de la plate-forme après pliage de sorte que la plate-forme (11) est au moins partiellement en surplomb par rapport à la face inférieure.

6. Embase selon la revendication 1, caractérisée en ce que ladite feuille, avant repliement, est munie d'ouvertures au niveau des lignes de pliage et au moins à l'extérieur des lignes de pliage.

7. Embase selon la revendication 1, caractérisée en ce qu'elle est constituée à partir d'une feuille d'aluminium.

## Claims

1. A base serving as a heat sink in a plastic casing, the upper surface (11) of the heat sink being in thermal contact with the semiconductor chip (1), the lower surface (15) being flush with a main surface of the casing, characterized in that it is formed by using a substantially square metal sheet having each of its corners folded as a tongue (15) to provide a substantially square platform (11), the surface including the folded tongues corresponding to the lower surface of the base, and in that fins (12) are coupled to the platform (11) by connecting arms (13).

2. The base of claim 1, characterized in that each connecting arm (13) is curved so that, after folding, the lower surface of the fins is positioned along the same plane as the lower surface of the tongues.

3. The base of claim 1, characterized in that the connecting arms of the fins substantially extend from the central portions of the platform sides before the tongues are folded.

4. The base of claim 1, characterized in that the tongues are folded so that they do not contact each other.

5. The base of claim 1, characterized in that the folded tongues do not contact each other at least near the corners of the platform after folding so that the platform (11) at least partially protrudes with respect to the lower surface.

6. The base of claim 1, characterized in that said metal sheet, before being folded, includes apertures near the folding lines, and at least externally with respect to the folding lines.

7. The base of claim 1, characterized in that it is formed from an aluminum sheet.

## Patentansprüche

1. Basis, die als Wärmesenke in einem Kunststoffgehäuse dient, wobei die obere Seite (11) der Basis in thermischem Kontakt mit einem Halbleiter-Chip (1) ist und die untere Seite (15) glatt mit einer Hauptseite des Gehäuses abschließt, dadurch gekennzeichnet, dass sie aus einer im wesentlichen quadratischen Metallfolie gebildet ist, deren jede Ecke zu einer Zunge (15) gefaltet ist, um eine im wesentlichen quadratische Plattform (11) zu erhalten, wobei die Faltungen enthaltende Seite der unteren Seite der Plattform entspricht, und dass Flügel (12) mit der Plattform (11) durch Verbindungsarme (13) verbunden sind.

2. Basis nach Anspruch 1, dadurch gekennzeichnet, dass jeder der Verbindungsarme (13) abgebogen ist, damit, nach dem Falten, die untere Seite der Flügel sich in der selben Ebene wie die untere Seite der Zungen befindet.

3. Basis nach Anspruch 1, dadurch gekennzeichnet, dass vor dem Falten der Zungen die Verbindungsarme der Flügel im wesentlichen von der Mitte der Seiten der Plattform ausgehen.

4. Basis nach Anspruch 1, dadurch gekennzeichnet, dass die Faltungen der Zungen einander nicht berühren.

5. Basis nach Anspruch 1, dadurch gekennzeichnet, dass die Faltungen nach dem Falten zumindest im Bereich der Ecken der Plattform einander nicht berühren, derart, dass die Plattform (11) wenigstens teilweise über die untere Seite hinausragt.

6. Basis nach Anspruch 1, dadurch gekennzeichnet, dass die erwähnte Folie vor dem Falten im Bereich der Faltungslinien und zumindest außerhalb der Faltungslinien mit Öffnungen versehen ist.

7. Basis nach Anspruch 1, dadurch gekennzeichnet, dass sie aus einer Aluminiumfolie gebildet ist.
